**Europäisches Patentamt**

**European Patent Office**

**Office européen des brevets**

(19)

(11) **EP 1 260 825 A1**

(12) **EUROPÄISCHE PATENTANMELDUNG**

(43) Veröffentlichungstag:
**27.11.2002 Patentblatt 2002/48**

(51) Int Cl.$^7$: **G01R 33/02**

(21) Anmeldenummer: **01810518.9**

(22) Anmeldetag: **25.05.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **SENTRON AG**
**6300 Zug (CH)**

(72) Erfinder:
• **Popovic, Radivoje**
**1025 St-Sulpice (CH)**

• **Racz, Robert**
**6300 Zug (CH)**
• **Schott, Christian**
**1110 Morges (CH)**

(74) Vertreter: **Falk, Urs, Dr.**
**Patentanwaltsbüro Dr. Urs Falk,**
**Eichholzweg 9A**
**6312 Steinhausen (CH)**

(54) **Magnetfeldsensor**

(57)     Ein Magnetfeldsensor für die Messung von wenigstens zwei Komponenten eines Magnetfeldes umfasst einen auf einem Halbleiterchip (1) aufgebrachten ferromagnetischen Kern (4), eine mit einem Strom beaufschlagbare Erregerspule (2) und zwei Auslesesensoren (5, 6). Der ferromagnetische Kern (4) ist ringförmig. Die Erregerspule (2) ist bevorzugt gebildet aus Leiterbahnen (9, 10; 23) des Halbleiterchips (1) und aus Bonddrähten (11, 12; 24).

**Fig. 1**

**EP 1 260 825 A1**

**Beschreibung**

Die Erfindung betrifft einen Magnetfeldsensor der im Oberbegriff des Anspruchs 1 genannten Art.

Solche Magnetfeldsensoren eignen sich für die Messung von Magnetfeldern, deren Stärke nur wenige nT bis mT beträgt, beispielsweise als Kompass zur Messung der Richtung des Magnetfeldes der Erde.

Ein Magnetfeldsensor der im Oberbegriff des Anspruchs 1 genannten Art ist aus dem Artikel "CMOS planar 2D micro-fluxgate sensor" der Autoren L. Chiesi, P. Kejik, B. Janossy und R.S. Popovic bekannt, der in der Zeitschrift Sensors and Actuators 82 (2000) 174 - 180 veröffentlicht wurde. Ein solcher Magnetfeldsensor enthält einen ferromagnetischen Kern und eine von einem Wechselstrom durchflossene Erregerspule, um den Kern im Wechsel magnetisch zu sättigen und zu entmagnetisieren. Ein gewichtiger Nachteil dieses Sensors liegt darin, dass eine ausreichende Empfindlichkeit mit einem relativ grossen ferromagnetischen Kern erkauft werden muss. Dies steht einer weitergehenden Miniaturisierung entgegen und macht den Sensor relativ teuer. Ein weiteres Problem besteht darin, dass der ferromagnetische Kern unbeabsichtigt durch ein äusseres Magnetfeld, welches sehr viel grösser ist als das eigentlich zu messende Feld, magnetisiert werden kann. Der in der Spule fliessende Strom schafft es dann nicht mehr, die einzelnen magnetischen Bezirke frei auszurichten, was zu einem Messfehler führt.

Der Erfindung liegt die Aufgabe zugrunde, ein Konzept für Magnetfeldsensoren zu entwickeln, das eine weitergehende Miniaturisierung ermöglicht.

Die Erfindung besteht in den im Anspruch 1 angegebenen Merkmalen. Vorteilhafte Ausgestaltungen ergeben sich aus den abhängigen Ansprüchen.

Die Erfindung geht aus von einem Fluxgate Sensor aus, wie er z.B. aus dem obenerwähnten Artikel bekannt ist. Fluxgate Sensoren weisen eine Erregerspule, einen ferromagnetischen Kern und eine Auslesespule auf. Sie sind geeignet für die Messung schwacher Magnetfelder, da das zu messende Magnetfeld mit Hilfe der Erregerspule und des ferromagnetischen Kerns gechoppert wird, d.h. am Ort der Auslesepule periodisch ein- und ausgeschaltet wird. Das Ausgangssignal der Auslesepule lässt sich dann mit der Lock-In Technik synchron zur Chopperung auswerten. Die Erfindung schlägt vor, für die Optimierung der Eigenschaften eines für die Messung schwacher Magnetfelder vorgesehenen Magnetfeldsensors alle in der Halbleitertechnologie gebräuchlichen Prozesse einzubeziehen, d.h. alle Prozesse vom Beginn der Herstellung der Halbleiterchips auf einem Wafer über das Postprocessing, wo der ferromagnetische Kern aufgebracht wird, bis zum Backend, wo der Halbleiterchip montiert und zum fertigen Magnetfeldsensor verkapselt wird. Dieser Ansatz ermöglicht die Verwendung eines ringförmigen ferromagnetischen Kerns, dessen Vorteil darin liegt, dass er sich mit einem Mimimum an elektrischem Strom und an elektrischer Leistung magnetisch in Sättigung bringen lässt. Die Windungen der Erregerspule bestehen dann vorteilhafterweise aus Leiterbahnen und Bonddrähten. Zudem schlägt die Erfindung vor, anstelle der Auslesespulen Hallelemente zu verwenden, da deren Grösse ohne Verlust an Empfindlichkeit beliebig verkleinert werden kann. Ein solcher Magnetfeldsensor 1ässt sich sehr stark miniaturisieren.

Nachfolgend werden Ausführungsbeispiele der Erfindung anhand der Zeichnung näher erläutert.

Es zeigen:

Fig. 1    einen Magnetfeldsensor mit einer Erregerspule und einem ferromagnetischen Kern zum Choppern des Messfeldes,

Fig. 2A, B    Feldlinien eines Magnetfeldes,

Fig. 3    einen Magnetfeldsensor mit einer Erregerspule mit mehreren Windungen,

Fig. 4    einen als Flipchip montierten Magnetfeldsensor,

Fig. 5    einen weiteren Magnetfeldsensor,

Fig. 6    einen Magnetfeldsensor mit einer als Flachspule ausgebildeten Erregerspule,

Fig. 7    Details einer weiteren Erregerspule, und

Fig. 8    einen Fluxgate Sensor.

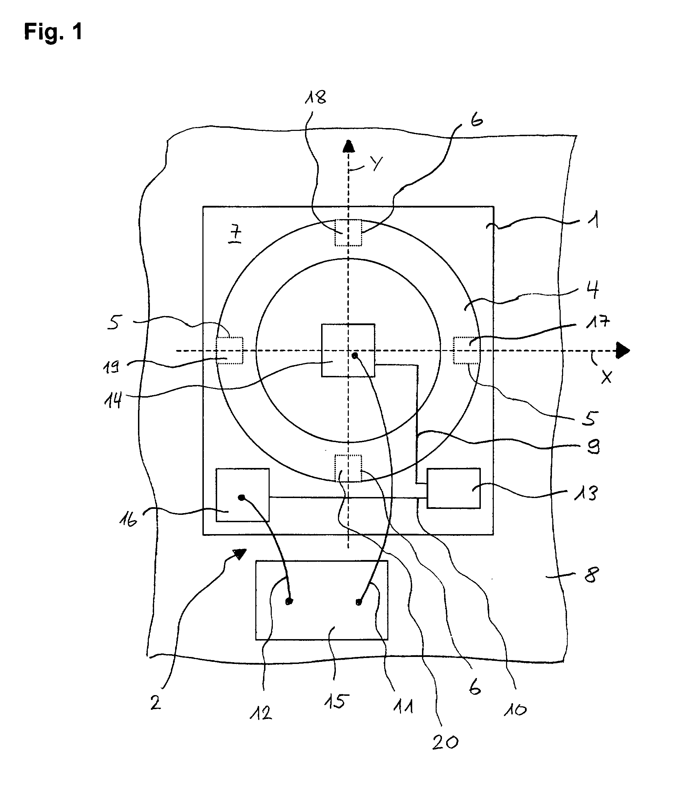

Die Fig. 1 zeigt in Aufsicht einen als Halbleiterchip 1 ausgebildeten Magnetfeldsensor für die Messung von zwei Komponenten eines Magnetfeldes. Als Bezugssystem dient ein kartesisches x,y,z Koordinatensystem, wobei die z-Richtung senkrecht zur Zeichenebene verläuft. Der Magnetfeldsensor umfasst eine mit einem Strom beaufschlagbare Erregerspule 2 mit mindestens einer Windung, einen ringförmigen ferromagnetischen Kern 4, zwei Auslesesensoren 5, 6 und eine elektronische Schaltung 7. Der Auslesesensor 5 dient der Erfassung der x-Komponente des Magnetfeldes, der Auslesesensor 6 dient der Erfassung der y-Komponente des Magnetfeldes. Vorzugsweise bestehen die Auslesesensoren 5, 6 je aus zwei örtlich getrennten, aber elektrisch verbundenen Sensoren. Der Magnetfeldsensor ist in einer Technologie hergestellt, bei der zunächst die elektronische Schaltung 7, Teile der Erregerspule 2 und die Auslesesensoren 5, 6 in einer Standard CMOS Technologie gefertigt und anschliessend der ferromagnetische Kern 4 in einem sogenannten Post-Prozess aufgebracht wurde. Dabei wird ein Band aus amorphem ferromagnetischem Material auf den Wafer mit den Halbleiterschaltungen aufgeklebt und mittels Photolithografie und chemischem Ätzen strukturiert. Nach dem Zersägen des Wafers in die einzelnen Halbleiterchips wird die mindestens eine Windung der Erregerspule 2 bei der Montage des Halbleiterchips auf ein Substrat 8 entweder durch Drahtbonden oder mittels der Flipchip Technologie vervollständigt. Die elektronische Schaltung 7 dient der Erzeugung des die Erregerspule 2 durchfliessenden Stromes und der Auswertung der von den Auslesesensoren 5, 6 gelieferten Signale.

Bei dem in der Fig. 1 gezeigten Ausführungsbeispiel weist die Erregerspule 2 eine einzige Windung auf, die teilweise aus einer ersten Leiterbahn 9 und einer zweiten Leiterbahn 10 und teilweise aus zwei Bonddrähten 11 und 12 besteht. Die erste Leiterbahn 9 führt von einer ausserhalb des ringförmigen ferromagnetischen Kerns 4 angeordneten Stromquelle 13 unter dem ferromagnetischen Kern 4 hindurch zu einem innerhalb des ringförmigen ferromagnetischen Kerns 4 angeordneten ersten Bondpad 14. Der erste Bonddraht 11 führt vom ersten Bondpad 14 zu einem Bondpad 15 auf dem Substrat 8. Der zweite Bonddraht 12 führt von diesem Bondpad 15 zu einem zweiten, ausserhalb des ringförmigen ferromagnetischen Kerns 4 auf dem Halbleiterchip 1 angeordneten Bondpad 16. Die zweite Leiterbahn 10 führt vom zweiten Bondpad 16 zur Stromquelle 13.

Als Material für den ferromagnetischen Kern 4 dient beispielsweise das unter der Bezeichnung VAC 6025Z erhältliche Band aus amorphem Metall. Dieses Material hat eine Koerzitivfeldstärke $H_C$ = 3 mA/cm. Um den ferromagnetischen Kern 4 magnetisch in Sättigung zu bringen, sollte der durch die Erregerspule 2 fliessende Strom I ein Magnetfeld $H_S$ erzeugen, das etwa 20 mal grösser als die Koerzitivfeldstärke $H_C$ ist. Wenn der äussere Durchmesser D des ringförmigen ferromagnetischen Kerns 4 D = 300 μm und die Zahl n der Windungen der Erregerspule 2 n = 1 beträgt, dann erhält man für den Strom gemäss der Gleichung

$$I = 20 * H_C * D * \pi / n \qquad (1)$$

$I \cong 6$ mA. Der Duty Cycle des Stroms I kann zudem auf etwa 10% reduziert werden, wodurch sich der mittlere Strombedarf auf 0.6 mA reduziert. Da der ferromagnetische Kern 4 keinen Luftspalt hat, lässt er sich bereits durch ein kleines Magnetfeld und somit durch einen geringen Strom I magnetisch sättigen.

Der Magnetfeldsensor weist als Auslesesensoren 5 und 6 vier elektrisch paarweise gekoppelte, sogenannte horizontale Hallelemente 17, 18, 19 und 20 auf, die auf ein Magnetfeld empfindlich sind, das senkrecht zur Oberfläche des Halbleiterchips 1, d.h. in z-Richtung verläuft. Die Hallelemente 17 und 19 sind auf der x-Achse des kartesischen Koordinatensystems angeordnet und bilden den ersten Auslesesensor 5, die Hallelemente 18 und 20 sind auf der y-Achse des kartesischen Koordinatensystems angeordnet und bilden den zweiten Auslesesensor 6. Die Hallelemente 17 bis 20 sind jeweils unterhalb des ferromagnetischen Kerns 4 angeordnet und zwar in der Nähe des äusseren Randes des ferromagnetischen Kerns 4.

Im Betrieb arbeitet der Magnetfeldsensor wie folgt: Die Erregerspule 2 wird von der Stromquelle 13 mit einem vorzugsweise rechteckförmigen Wechselstrom beaufschlagt. Der Wechselstrom sättigt und entmagnetisiert dabei den ferromagnetischen Kern 4 mit der Frequenz des Wechselstromes. In der Phase, wo der ferromagnetische Kern 4 magnetisch gesättigt ist, übt er auf das zu messende, externe Magnetfeld keine Wirkung aus. Die Feldlinien des Magnetfeldes verlaufen parallel zur Oberfläche der Hallelemente 17 bis 20: Die Hallelemente liefern keinAusgangssignal. In der Phase, wo der ferromagnetische Kern 4 entmagnetisiert ist, wirkt er auf das zu messende Magnetfeld als magnetischer Flusskonzentrator. Da die relative Permeabilität $\mu_r$ des ferromagnetischen Kerns 4 sehr gross gegenüber der relativen Permeabilität seiner Umgebung ist, treffen die Feldlinien des Magnetfeldes annähernd senkrecht auf die Oberfläche des ferromagnetischen Kerns 4 auf bzw. verlassen diesen unter fast senkrechtem Winkel. Die Feldkonzentration ist am grössten im Bereich des Randes des ferromagnetischen Kerns 4, wo sich die Hallelemente 17 bis 20 befinden. Die Ausgangssignale von mindestens zwei der vier Hallelemente 17 bis 20 sind dann verschieden von Null.

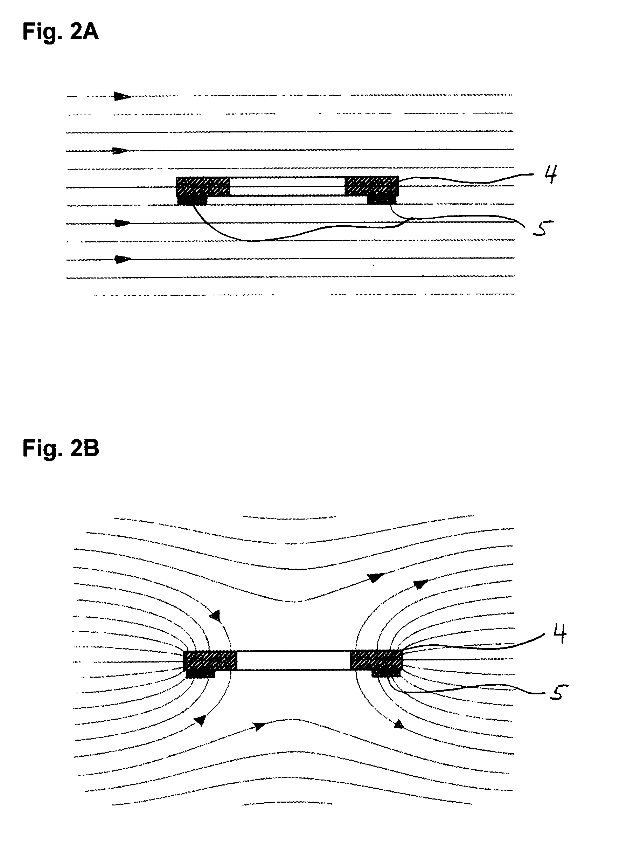

Die Fig. 2A zeigt die Feldlinien 21 des Magnetfeldes, wenn der ferromagnetische Kern 4 gesättigt ist und wenn das Magnetfeld entlang der x-Richtung und somit parallel zur Oberfläche des Halbleiterchips 1 verläuft. Dargestellt sind nur der ferromagnetische Kern 4 und zwei Auslesesensoren 5. Die Schnittebene der Figur verläuft senkrecht zur Oberfläche des Halbleiterchips 1 und parallel zum äusseren Magnetfeld. Die Fig. 2B zeigt die Feldlinien 22 desselben Magnetfeldes, wenn der ferromagnetische Kern 4 durch das von dem durch die Erregerspule fliessenden Strom nicht gesättigt ist. Die Feldlinien am Ort der beiden Auslesesensoren 5 zeigen in unterschiedliche z-Richtung, da das Magnetfeld am Ort des einen Auslesesensors 5 (in der Fig. 2B beispielsweise des linken Auslesesensors 5) in den ferromagnetischen Kern 4 eintritt und am Ort des anderen Auslesesensors 5 (in der Fig. 2B des rechten Auslesesensors 5) diesen wieder verlässt. Die beiden Auslesesensoren 5 sind elektrisch entsprechend geschaltet.

Die Erregerspule 2 dient also dazu, den ferromagnetischen Kern zur Chopperung des zu messenden Magnetfeldes zu benützen. Die Ausgangssignale der Hallelemente 17 bis 20 können dann mittels der bekannten Lock-In Technik synchron mit dem durch die Erregerspule 2 fliessenden Strom ausgewertet werden.

Im folgenden werden nun weitere Massnahmen beschrieben, deren Anwendung zu einer höheren Empfindlichkeit des Magnetfeldsensors und/oder zu einem geringeren Strom- bzw. Energieverbrauch führt.

Wenn die Zahl der Windungen der Erregerspule 2 auf n erhöht wird, dann kann bei gleichem Stromverbrauch entweder der durch die Erregerspule 2 fliessende Strom um den Faktor n verkleinert oder der Durchmesser D des ringförmigen ferromagnetischen Kerns 4 um den Faktor n vergrössert werden. Eine Vergrösserung des Durchmessers D bewirkt eine Verstärkung der Flusskonzentration, erhöht aber auch den Platzbedarf und damit die Abmessungen des Halbleiterchips 1. Im Hinblick auf das Ziel einer möglichst grossen Miniaturisierung des Magnetfeldsensors resultieren dann optimale Verhältnisse, wenn der Durchmesser D des ferromagnetischen Kerns 4 den Abmessungen des Halbleiterchips 1 angepasst wird, wie sie sich aus dem Platzbedarf für die elektronische Schaltung 7 ergeben, und die Zahl n der Windungen 3 der Grösse des ferromagnetischen Kerns 4 angepasst wird.

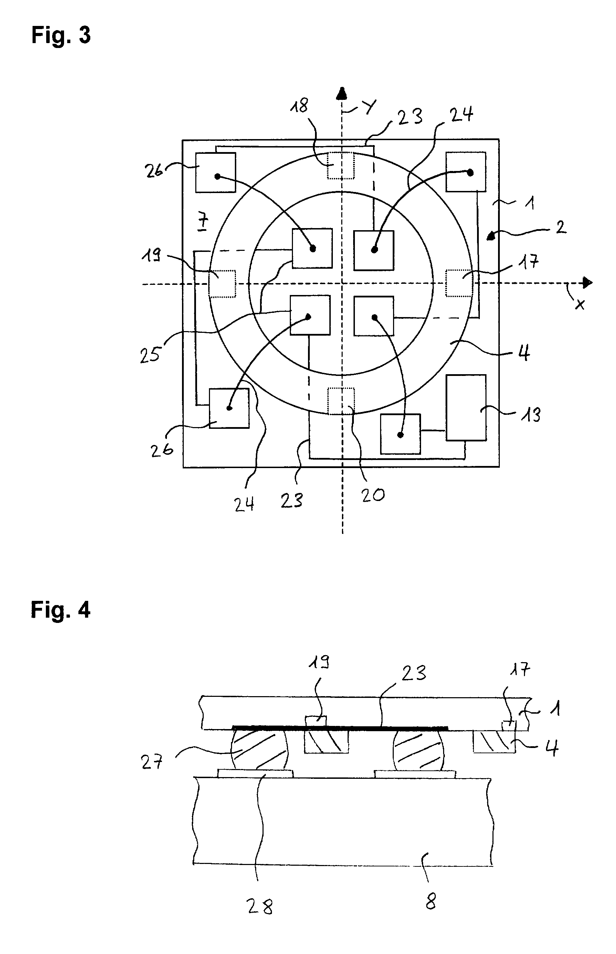

Die Fig. 3 zeigt in Aufsicht einen Magnetfeldsensor, dessen Erregerspule 2 vier in Reihe geschaltete Windungen aufweist. Die Windungen bestehen je aus einer Leiterbahn 23 und einem Bonddraht 24, wobei jeder Bonddraht 24 von einem Bondpad 25 innerhalb des ferromagnetischen Kerns 4 zu einem Bondpad 26 ausserhalb des ferromagnetischen Kerns 4 führt. Bei diesem Beispiel befinden sich alle Bondpads auf dem Halbleiterchip 1.

Die Fig. 4 zeigt im Schnitt einen als Flipchip montierten Magnetfeldsensor, bei dem die Windungen der Erregerspule mittels Leiterbahnen 23 auf dem Halbleiterchip 1, sogenannten Bumps 27 und Leiterbahnen 28 auf dem Substrat 8 realisiert sind.

Mit den beschriebenen Magnetfeldsensoren kann auch die z-Komponente des Magnetfeldes gemessen werden. Anders als bei einem parallel zur Oberfläche des Halbleiterchips 1 verlaufenden Magnetfeld zeigen hier die Feldlinien des Magnetfeldes bei allen Auslesesensoren 5, 6 bzw. Hallelementen 17 bis 20 in die gleiche Richtung. Die Hallelemente 17 bis 20 sind dann diesem Umstand entsprechend zu beschalten. Für die Messung der horizontal zur Oberfläche des Halbleiterchips 1 verlaufenden Komponenten des Magnetfeldes, d.h. der x- und der y-Komponente, muss die Differenz der Ausgangsspannungen der beiden Hallelemente 17 und 19 bzw. der beiden Hallelemente 18 und 20 ermittelt werden, während für die Messung der senkrecht zur Oberfläche des Halbleiterchips 1 verlaufenden z-Komponente die Summe der Ausgangsspannungen der Hallelemente 17 bis 20 ermittelt werden muss.

Solange die Dicke des ferromagnetischen Kerns 4, d.h. seine Ausdehnung in z-Richtung, vergleichsweise klein gegenüber seiner Breite ist, wirkt der ferromagnetische Kern 4 für die z-Komponente des Magnetfeldes nicht als Flusskonzentrator. Wenn die Dicke jedoch vergleichbar zu seiner Breite wird, dann wirkt der ferromagnetische Kern 4 auch als Flusskonzentrator für die z-Komponente des Magnetfeldes. Dann lässt sich das Magnetfeld mittels dem durch die Erregerspule fliessenden Strom auch bei der Messung der z-Komponente choppern, was die Empfindlichkeit des Magnetfeldsensors für die z-Komponente markant erhöht. Die Dicke des ferromagnetischen Kerns 4 beträgt dann bevorzugt mindestens das 0.5 fache seiner Breite.

Der durch die Erregerspule 2 fliessende Strom kann auch zur Speisung der Hallelemente 17 bis 20 verwendet werden, da der ohmsche Widerstand der Erregerspule 2 klein ist.

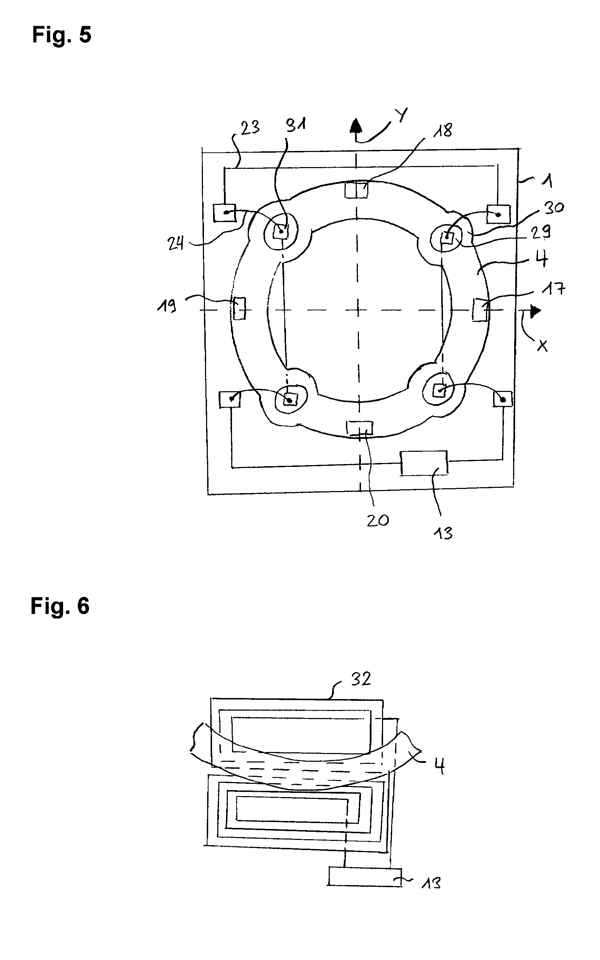

Eine weitere Massnahme zur Erhöhung der Effizienz des Magnetfeldsensors besteht darin, den ferromagnetischen Kern 4 lokal zu verengen und die Erregerspule derart auszugestalten, dass der ferromagnetische Kern 4 lokal in magnetische Sättigung kommt. Das Magnetfeld wird dann im Bereich der Auslesesensoren 5, 6, d.h. der Hallelemente 17 bis 20, immer noch ausreichend gechoppert. Die Fig. 5 zeigt in der Aufsicht einen derart modifizierten Magnetfeldsensor. Der ringförmige ferromagnetische Kern 4 mit dem Durchmesser D beinhaltet vier Löcher 29, so dass vier kleine Ringe 30 entstehen, die je zwischen zwei der Hallelemente 17 bis 20 angeordnet sind. Beispielsweise weisen der grosse Ring einen Durchmesser D = 1.5 mm und die kleinen Ringe 30 einen Durchmesser d = 150 um auf. Innerhalb jedes der kleinen Ringe 30 befindet sich ein Bondpad 31. Die Erregerspule besteht wiederum aus Leiterbahnen 23 und Bonddrähten 24, die so ausgelegt und verdrahtet sind, dass der durch die Erregerspule fliessende Strom die kleinen Ringe 30 in Sättigung bringt. Unabhängig vom Durchmesser D des grossen Rings genügt bei Verwendung des Metallbandes VAC 6025Z ein gemäss Gleichung (1) berechneter Strom I $\cong$ 3 mA zur magnetischen Sättigung der kleinen Ringe 30. Wenn die kleinen Ringe 30 gesättigt sind, dann verliert der grosse Ring seine Funktion als Flusskonzentrator: Das externe Magnetfeld wird gechoppert.

Die Fig. 6 zeigt in der Aufsicht einen Ausschnitt eines Magnetfeldsensors, bei dem die Erregerspule in der Form einer Flachspule 32 ausgebildet ist. Die Flachspule 32 belegt einen Teil des Platzes unterhalb des ringförmigen ferromagnetischen Kerns 4. Da die von der Flachspule 32 erzeugten magnetischen Feldlinien nicht innerhalb des ferromagnetischen Kerns 4 geschlossen werden können, entstehen Störfelder. Die Abmessungen der Flachspule 32 sollten daher klein sein im Vergleich zum Durchmesser D des ferromagnetischen Kerns 4 und die Flachspule 32 sollte möglichst weit von den Auslesesensoren 5, 6 (bzw. Hallelementen 17 - 20) entfernt sein. Die Flachspule 32 besteht aus zwei gegensinnig gewickelten Teilspulen, wovon die eine Teilspule im wesentlichen innerhalb des ferromagnetischen Kerns 4, die andere Teilspule ausserhalb des ferromagnetischen Kerns 4 angeordnet ist. Die Teilspulen sind, wie in der Fig. 6 dargestellt, so gewickelt, dass der Strom, der durch die nahe beim ferromagnetischen Kern 4 verlaufenden Windungsteile fliesst, in die gleiche Richtung fliesst. Anstelle einer einzigen Flachspule können auch mehrere Flachspulen entlang dem ferromagnetischen Kern 4 angeordnet werden.

Bei den heutigen CMOS Prozessen sind mehrere Metallebenen üblich. Diese Metallebenen lassen sich für die Realisierung der Flachspulen benützen, soweit sie nicht für die elektronische Schaltung 7 erforderlich sind.

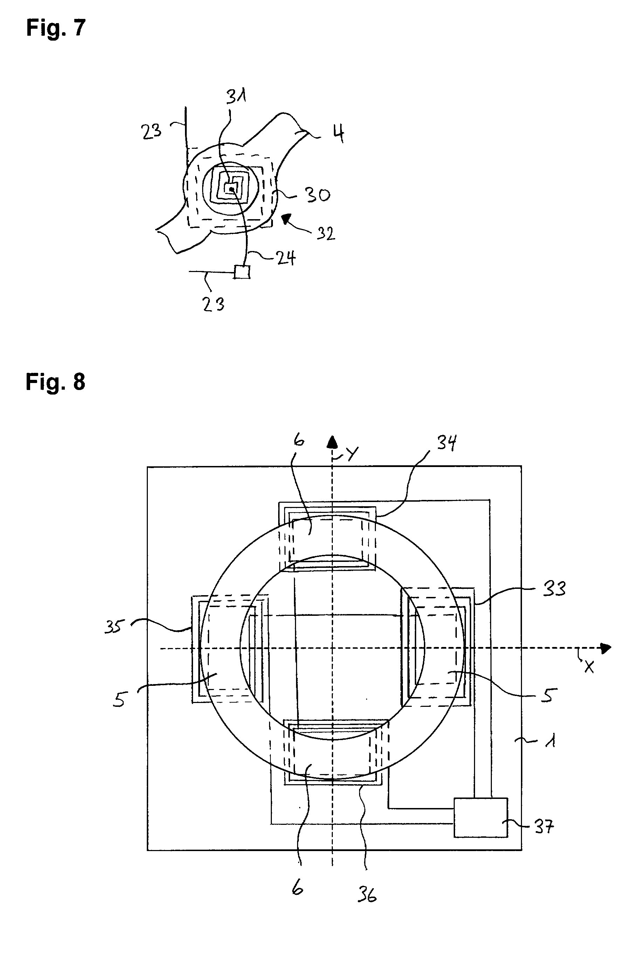

Die Vorschläge gemäss den Figuren 5 und 6 lassen sich kombinieren. In der Fig. 7 ist ein nur einen der kleinen Ringe 30 umfassender Ausschnitt des Magnetfeldsensors gemäss Fig. 5 gezeigt. Unterhalb des kleinen Ringes 30 ist eine Flachspule 32 angeordnet, deren Windungen das Bondpad 31 spiralförmig umkreisen. Die Erregerspule umfasst bei dieser Lösung die Flachspule 32 und die aus der Leiterbahn 23 und aus dem Bonddraht 24 gebildeten Windungen.

Wenn eine möglichst starke Miniaturisierung des Magnetfeldsensors angezielt wird, dann ist die Ausbildung der Auslesesensoren 5, 6 als Hallelement die richtige Wahl. Wenn andererseits eine möglichst hohe Empfindlichkeit angezielt wird, damit auch extrem kleine Magnetfelder gemessen werden können, dann ist es einerseits erforderlich, den Durchmesser D des ringförmigen ferromagnetischen Kerns 4 relativ gross zu machen, und andererseits sinnvoll, als Auslesesensoren 5, 6 Flachspulen vorzusehen. Die Empfindlichkeit der Flachspulen nimmt nämlich quadratisch mit dem zur Verfügung stehenden Platz und damit quadratisch mit dem Durchmesser D zu, während die Empfindlichkeit der Hallelemente unabhängig von ihrer Grösse ist und damit nur linear mit dem Durchmesser D zunimmt. Bei allen gezeigten Ausführungsbeispielen können daher die Hallelemente durch Flachspulen ersetzt werden. Beispielhaft zeigt die Fig. 8 in der Aufsicht einen Magnetfeldsensor mit Flachspulen 33 bis 36, die als Auslesesensoren 5, dienen. Der Klarheit wegen ist die Erregerspule nicht gezeichnet. Die Flachspulen 33 bis 36 sind so gewickelt, dass ihre Windungen das Magnetfeld umschliessen, das wie in der Fig. 2B gezeigt ist, senkrecht zu ihrer Oberfläche verläuft. Die Flachspulen 33 bis 36 sind bevorzugt rechteckförmig oder in ihrer Form der Krümmung des Ringes angepasst, damit ihre Windungen einen möglichst grossen Abschnitt des ferromagnetischen Kerns 4 und damit einen möglichst grossen Anteil des magnetischen Flusses umschliessen. Der Auslesesensor 5 umfasst die beiden Flachspulen 33 und 35, die gegensinnig gewickelt sind, so dass sich ihre Nutzsignale addieren. Der Auslesesensor 6 umfasst die beiden Flachspulen 34 und 36. Die Flachspulen 33 bis 36 sind mit einem Auswerteschaltkreis 37 verbunden. Ein solcher Magnetfeldsensor wird auch als Fluxgate Sensor bezeichnet.

**Patentansprüche**

1. Magnetfeldsensor für die Messung von wenigstens zwei Komponenten eines Magnetfeldes, mit einem auf einem Halbleiterchip (1) aufgebrachten ferromagnetischen Kern (4), einer mit einem Strom beaufschlagbaren Erregerspule (2) und mit zwei Auslesesensoren (5, 6), **dadurch gekennzeichnet, dass** der ferromagnetische Kern (4) ringförmig ist.

2. Magnetfeldsensor nach Anspruch 1, **dadurch gekennzeichnet, dass** die Erregerspule (2) aus Leiterbahnen (9, 10; 23) des Halbleiterchips (1) und aus Bonddrähten (11, 12; 24) besteht.

3. Magnetfeldsensor nach Anspruch 1, **dadurch gekennzeichnet, dass** die Erregerspule (2) aus Leiterbahnen (23) des Halbleiterchips (1) und aus Leiterbahnen (28) auf einem Substrat (8) besteht, die durch Bumps (27) elektrisch verbunden sind.

4. Magnetfeldsensor nach einem der Ansprüche 1 bis 3, **dadurch gekennzeichnet, dass** der ferromagnetische Kern (4) wenigstens vier Löcher (29) aufweist und dass die Erregerspule (2) im Bereich der Löcher (29) angeordnete Windungen aufweist.

5. Magnetfeldsensor nach einem der Ansprüche 1 bis 4, **dadurch gekennzeichnet, dass** als Auslesesensoren (5, 6) Hallelemente (17, 18, 19, 20) vorgesehen sind und dass die Hallelemente (17, 18, 19, 20) unterhalb des ferromagnetischen Kerns (4) angeordnet sind.

6. Magnetfeldsensor nach Anspruch 5, **dadurch gekennzeichnet, dass** jeder Auslesesensor (5, 6) zwei Hallelemente (17, 19; 18, 20) umfasst.

7. Magnetfeldsensor nach einem der Ansprüche 1 bis 6, **dadurch gekennzeichnet, dass** die Dicke des ferromagnetischen Kerns (4) mindestens das 0.5 fache seiner Breite beträgt.

**Fig. 1**

**Fig. 2A**

**Fig. 2B**

**Fig. 3**

**Fig. 4**

**Fig. 5**

**Fig. 6**

**Fig. 7**

**Fig. 8**

**Europäisches Patentamt**

## EUROPÄISCHER RECHERCHENBERICHT

Nummer der Anmeldung

EP 01 81 0518

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 0 359 922 A (LANDIS & GYR BETRIEBS AG) 28. März 1990 (1990-03-28) * Zusammenfassung; Abbildungen 7,8 * * Spalte 4, Zeile 30 - Spalte 5, Zeile 34 * * Spalte 6, Zeile 26 - Zeile 28 * | 1-4,7 | G01R33/02 |
| A | US 4 692 703 A (EXTANCE PHILIP ET AL) 8. September 1987 (1987-09-08) * Zusammenfassung; Abbildungen 3-5 * | 5,6 | |
| X | US 5 199 178 A (LAM FAI-LOY P ET AL) 6. April 1993 (1993-04-06) * Zusammenfassung; Abbildungen 3A,10,11 * * Spalte 3, Zeile 60 - Spalte 4, Zeile 12 * * Spalte 8, Zeile 17 - Zeile 20 * | 1 | |
| E | FR 2 802 650 A (COMMISSARIAT ENERGIE ATOMIQUE) 22. Juni 2001 (2001-06-22) * Zusammenfassung; Anspruch 8; Abbildungen * * Seite 6, Zeile 8 - Zeile 22 * | 1 | RECHERCHIERTE SACHGEBIETE (Int.Cl.7) G01R G01C |
| E | WO 01 44826 A (COMMISSARIAT ENERGIE ATOMIQUE ;CUCHET ROBERT (FR); DURET DENIS (FR) 21. Juni 2001 (2001-06-21) * Zusammenfassung; Abbildungen 1A,5-7 * * Seite 8, Zeile 15 - Zeile 16 * | 1 | |
| X | EP 0 893 699 A (TOKIN CORP) 27. Januar 1999 (1999-01-27) * Zusammenfassung; Abbildungen 6,9,12-14 * | 1-3 | |
| A | GB 2 340 251 A (SAMSUNG ELECTRONICS CO LTD) 16. Februar 2000 (2000-02-16) * Zusammenfassung; Abbildungen * | 1 | |

-/--

Der vorliegende Recherchenbericht wurde für alle Patentansprüche erstellt

| Recherchenort | Abschlußdatum der Recherche | Prüfer |
|---|---|---|
| BERLIN | 25. Oktober 2001 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 1 052 519 A (ASULAB SA) 15. November 2000 (2000-11-15) * Zusammenfassung; Abbildungen * ----- | 1 | |
| | | | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| BERLIN | 25. Oktober 2001 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 01 81 0518

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-10-2001

| Im Recherchenbericht angeführtes Patentdokument | | Datum der Veröffentlichung | Mitglied(er) der Patentfamilie | | Datum der Veröffentlichung |
|---|---|---|---|---|---|
| EP 0359922 | A | 28-03-1990 | EP | 0359922 A1 | 28-03-1990 |
| | | | US | 4963827 A | 16-10-1990 |
| US 4692703 | A | 08-09-1987 | GB | 2154744 A | 11-09-1985 |
| | | | AU | 3849085 A | 29-08-1985 |
| | | | EP | 0157470 A2 | 09-10-1985 |
| | | | JP | 60194379 A | 02-10-1985 |
| | | | NO | 850682 A | 26-08-1985 |
| US 5199178 | A | 06-04-1993 | WO | 9308450 A1 | 29-04-1993 |
| FR 2802650 | A | 22-06-2001 | FR | 2802650 A1 | 22-06-2001 |
| WO 0144826 | A | 21-06-2001 | FR | 2802649 A1 | 22-06-2001 |
| | | | WO | 0144826 A1 | 21-06-2001 |
| EP 0893699 | A | 27-01-1999 | EP | 0893699 A1 | 27-01-1999 |
| | | | JP | 2985079 B2 | 29-11-1999 |
| | | | JP | 11094922 A | 09-04-1999 |
| | | | US | 6181130 B1 | 30-01-2001 |
| GB 2340251 | A | 16-02-2000 | CN | 1244664 A | 16-02-2000 |
| EP 1052519 | A | 15-11-2000 | CN | 1274853 A | 29-11-2000 |
| | | | EP | 1052519 A1 | 15-11-2000 |
| | | | JP | 2001013231 A | 19-01-2001 |

EPO FORM P0461

Für nähere Einzelheiten zu diesem Anhang : siehe Amtsblatt des Europäischen Patentamts, Nr.12/82